(19) Europäisches Patentamt
European Patent Office
Office européen des brevets

(11) **EP 2 623 996 B1**

(12) **EUROPÄISCHE PATENTSCHRIFT**

(45) Veröffentlichungstag und Bekanntmachung des Hinweises auf die Patenterteilung:
**21.05.2014 Patentblatt 2014/21**

(51) Int Cl.:
*G01R 19/00* (2006.01)    *G01R 35/00* (2006.01)

(21) Anmeldenummer: **12153689.0**

(22) Anmeldetag: **02.02.2012**

(54) **Strommessschaltung und Verfahren zur Überwachung einer Funktionsfähigkeit einer Strommessschaltung**

Current measuring circuit and method for monitoring the correct operation of a current measuring circuit

Circuit de mesure de courant et procédé de surveillance d'un fonctionnement d'un circuit de mesure de courant

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**07.08.2013 Patentblatt 2013/32**

(73) Patentinhaber: **MAGNA STEYR Battery Systems GmbH & Co OG**
**8141 Zettling (AT)**

(72) Erfinder: **Erhart, Michael**
**8075 Hart bei Graz (AT)**

(74) Vertreter: **Rausch, Gabriele**
**Magna International Europe AG**
**Patentabteilung**
**Liebenauer Hauptstrasse 317**
**VG-Nord**
**8041 Graz (AT)**

(56) Entgegenhaltungen:
**EP-A2- 1 030 185         DE-A1- 10 310 503**
**DE-A1-102005 055 272     US-A- 5 426 416**
**US-A1- 2011 291 675**

**Beschreibung**

Die Erfindung betrifft eine Strommessschaltung, die eine Sensorbaugruppe zur Messung eines durch einen Leiter fließenden elektrischen Stroms mittels Messung einer Eingangsspannung zwischen einer ersten und einer zweiten Eingangsleitung der Sensorbaugruppe und eine Sensorsteuerung zur Steuerung der Sensorbaugruppe umfasst, wobei die Sensorbaugruppe eine erste Sensorvorrichtung zur Erfassung der Stärke des elektrischen Stroms mittels eines ersten Analog-Digital-Wandlers zur Wandlung von analogen Messwerten in digitalisierte Messwerte umfasst und die Strommessschaltung eine Beeinflussungsvorrichtung zur veränderlichen Aufschaltung einer Testspannung oder eines Teststroms auf einen Eingang des ersten Analog-Digital-Wandlers umfasst. Die Beeinflussungsvorrichtung zur veränderlichen Aufschaltung kann ein Schalter (beispielsweise ein Relais oder ein elektronischer Analogschalter) sein, mit dem eine elektrische Verbindung von einer Spannungs- oder Stromquelle zu dem Eingang des ersten Analog-Digital-Wandlers herstellbar und unterbrechbar ist. Statt des Schalters kann die Beeinflussungsvorrichtung eine Spannungs- oder Stromquelle umfassen, die eine Spannung bereitstellt, deren Höhe sich in vorbestimmter Weise (transient oder stationär) zeitlich verändert, oder die einen Strom bereitstellt, dessen Höhe sich in vorbestimmter Weise (transient oder stationär) zeitlich verändert.

Außerdem betrifft die Erfindung ein Verfahren zur Überwachung einer Funktionsfähigkeit einer Strommessschaltung.

Aus der US 5 426 416 A ist ein im wesentlichen temperaturinvarianter Stromsensor für den Einsatz in einem Kraftfahrzeug bekannt, der dazu eingerichtet ist einen Strom zu messen, der von einer Quelle elektrischer Energie an eine Last geliefert wird und konfiguriert ist beim Auftreten von internen Fehlern einen maximalen Strompegel anzuzeigen.

Aus der US 2011/291675 A1 ist ein System zum Messen eines Spannungsabfalls zwischen zwei Knoten in einer elektrischen Schaltung bekannt, wobei das System einen geschalteten Kondensator-Integrator (SCI), einen Komparator-Schaltkreis und einen Zähler umfasst.

Aus DE 10 2005 055 272 B4 ist eine Messvorrichtung zur Erfassung von Spannungsmesswerten an einem Leiterabschnitt bekannt, die fester Bestandteil eines Kraftfahrzeugs sein kann. Die Messvorrichtung umfasst einen Analog-Digital-Wandler und der Leiterabschnitt ist möglichst nahe bei einer Batterieklemme angeordnet. Die bekannte Messvorrichtung ist zur Messung der Größe von Leckströmen vorgesehen. In einem Verfahrensschritt wird in den Leiterabschnitt ein Messstrom bekannter Stärke aus einer aufschaltbaren Stromquelle eingeprägt und über den dadurch an dem Leiterabschnitt auftretenden Spannungsabfall der Widerstandswert des Leiterabschnitts ermittelt. Hierbei wird unterstellt, dass während der Widerstandsmessung das Zündschloss ausgeschaltet ist und somit allenfalls noch unbekannte Verbraucher mit einem kleinen Leckstrom einen Spannungsabfall in dem Leiterabschnitt verursachen, der im Vergleich zu dem Messstrom vernachlässigbar ist.

Mit der vorliegenden Erfindung soll eine Strommessschaltung bereitgestellt werden, deren Funktionsfähigkeit während eines regulären Betriebs eines Bordnetzes überprüft werden kann. Abgesehen davon, dass die bekannte Messvorrichtung nicht den Zweck hat, diese Aufgabe zu lösen, wäre sie aus folgendem Grund auch nicht dafür geeignet. Der Leiterabschnitt ist sowohl Teil des Verbraucherstromkreises als auch Teil des Teststromkreises. Damit fließt durch ihn die Summe der Ströme der beiden Stromkreise (1. Kirchhoffsches Gesetz). Im regulären Betrieb überwiegt der Spannungsabfall, den der Verbraucherstrom am Leiterabschnitt verursacht, den Spannungsabfall, den der Teststrom am Leiterabschnitt verursacht. Im Vergleich zu dem Verbraucherstrom hätte ein Teststrom noch praktikabler Stärke keine ausreichende Stärke, um einen noch zuverlässig auswertbaren Beitrag zum Spannungsabfall am Leiterabschnitt zu verursachen.

Die Aufgabe (trotz dieser Schwierigkeiten) eine Strommessschaltung bereitzustellen, deren Funktionsfähigkeit während eines regulären Betriebs eines Bordnetzes überprüft werden kann, wird mit dem unabhängigen Patentanspruch gelöst. Vorteilhafte Weiterbildungen des Erfindungsgedankens sind Gegenstand der Unteransprüche.

Erfindungsgemäß ist die bekannte Strommessschaltung dadurch weitergebildet, dass der Eingang des ersten Analog-Digital-Wandlers mit der ersten Eingangsleitung der Sensorbaugruppe über eine erste Vorschaltimpedanz verbunden ist. Die erste Vorschaltimpedanz zwischen der ersten Eingangsleitung der Sensorbaugruppe und dem Eingang des ersten Analog-Digital-Wandlers ändert zwar nichts daran, dass ein Teststrom noch praktikabler Stärke keine ausreichende Stärke hätte, um einen zuverlässig auswertbaren Einfluss auf den Spannungsabfall am Leiterabschnitt zu verursachen. Vorteilhafterweise ist es mit der erfindungsgemäßen Strommessschaltung jedoch möglich, die Eingangsspannung des ersten Analog-Digital-Wandlers mittels der Testspannung oder des Teststroms gezielt zu beeinflussen. So kann die Sensorsteuerung anhand beeinflussungsabhängiger Messwerte Rückschlüsse auf die Funktionsfähigkeit der Strommessschaltung durchführen. Die gezielte Beeinflussung ermöglicht der Sensorsteuerung eine Korrelation zwischen der gezielten Beeinflussung und erfassten Messwerten. Anhand der Korrelation kann die Sensorsteuerung aus den Messergebnissen Informationsanteile herausfiltern, die eine Systemantwort der Strommessschaltung auf die gezielte Beeinflussung des Eingangs des ersten Analog-Digital-Wandlers darstellen. Zur gezielten Beeinflussung kann als Testspannungsquelle oder als Teststromquelle eine Gleichspannungs- beziehungsweise Gleichstromquelle verwendet werden. Die Vorschaltimpedanz kann ein reiner Wirkwiderstand (d.h. ein Scheinwiderstand ohne Blindwiderstand) sein. Alternativ kann für die gezielte Beeinflussung eine Wechselspannungsquelle oder eine Wechselstromquelle verwendet werden, deren zeitlicher Verlauf und/oder Frequenzverteilung vorbestimmt (vorzugsweise stationär) ist. Beispielsweise kann die Wechselspannungs- oder Wechselstromquelle eine periodische Dreiecksspannung bereitstellen. Die Sensorsteuerung kann am Ende der Messkette diejenigen Wechselspannungsanteile aus dem Messsignal herausfiltern, zu denen die Wechselspannungs- oder Wechselstromquelle am Eingang des Analog-Digital-Wandlers beigetragen hat. Vorzugsweise enthält die gezielte Beeinflussung (durch die Wechselspannungs- oder Wechselstromquelle) Frequenzanteile in einem Frequenzbereich, die der auf dem Leiter zu messende Strom nicht enthält oder die in dem Leiter von der Strommessschaltung spezifikationsgemäß nicht zu messen sind. Um zu verhindern, dass die Wechselspannungs- beziehungsweise Wechselstromquelle auf dem Leiter eine unzulässige Störspannung verursacht, kann die erste Vorschaltimpedanz ein Filter (vorzugsweise ein Frequenzfilter, insbesondere bevorzugt ein Bandfilter oder einen Tiefpass) umfassen. In umgekehrter Richtung kann das Filter mittelbare Störungen der Selbsttestfunktion der Strommessschaltung durch Wechselspannungsanteile unterdrücken, die oberhalb einer Grenzfrequenz liegen, bei der Strom durch den Leiter von der Strommessschaltung erfasst werden sollen.

Die Sensorsteuerung ist dazu vorbereitet, an einem Eingang des ersten Analog-Digital-Wandlers einen definierten Betriebszustand herbeizuführen und mittels eines Vergleichs der digitalen Messwerte im definierten Betriebszustand mit vorbestimmten Soll-Messergebnissen die Funktionsfähigkeit der Strommessschaltung zu bewerten. Mittels eines Vergleichs mit vorbestimmten oder vorberechneten Soll-Messergebnissen, wird die Bewertung der Funktionsfähigkeit der Strommessschaltung vereinfacht. Die Bewertung kann so schneller und/oder öfter und/oder mit höherer Zuverlässigkeit durchgeführt werden.

Die Strommessschaltung kann einen Testreferenzeingang zum Anschluss einer Teststromquelle zum Bereitstellen des Teststroms oder zum Anschluss einer Testspannungsquelle zum Bereitstellen der Testspannung umfassen, insbesondere wobei ein Bezugspotentialanschluss der Testspannungsquelle mit einem Bezugspotentialanschluss des ersten Analog-Digital-Wandlers elektrisch verbunden ist. Hierdurch ist es möglich, für die Funktionsprüfung eine Spannungs- oder Stromquelle an die Strommessschaltung als separate Baueinheit anzuschließen und/oder eine Spannungs- oder Stromquelle mitzuverwenden, die für andere Zwecke in dem Fahrzeug ohnehin vorgesehen ist.

Die Strommessschaltung kann eine Steuerverbindung umfassen, mittels der die veränderliche Aufschaltung der Testspannung oder des Teststroms durch die Sensorsteuerung steuerbar ist. Die gezielte Beeinflussbarkeit der veränderlichen Aufschaltung der Testspannung oder des Teststroms durch die Sensorsteuerung ermöglicht der Sensorsteuerung eine zeitliche Korrelation zwischen einer Änderung der Aufschaltung und beobachteten Messergebnissen. Anhand der zeitlichen Korrelation kann die Sensorsteuerung aus den Messergebnissen Informationsteile herausfiltern, die eine Systemantwort der Strommessschaltung auf die Änderung der Aufschaltung darstellen. Alternativ kann eine Änderung der Aufschaltung der Testspannung oder des Teststrom erfolgen, indem die Steuerschaltung einen Betriebsparameter zur Testspannungs- beziehungsweise Teststromquelle sendet, den diese daraufhin anzuwenden hat.

Die Sensorbaugruppe kann eine erste Sensorvorrichtung zur Erfassung der Eingangsspannung und eine zweite Sensorvorrichtung zur Erfassung der Eingangsspannung umfassen, wobei beide Sensorvorrichtungen einen gemeinsamen Messbereich aufweisen. Hierdurch ist in dem gemeinsamen Messbereich eine Plausibilitätsprüfung zwischen den Messdaten, die von der ersten Sensorvorrichtung erfasst werden und den Messdaten, die von der zweiten Sensorvorrichtung erfasst werden, möglich.

Die Sensorsteuerung kann dazu vorbereitet sein, die Bewertung der Funktionsfähigkeit der Strommessschaltung auch unter Berücksichtigung von digitalen Messwerten durchzuführen, die von der zweiten Sensorvorrichtung erfassbar sind. Wenn Messwerte, die von den beiden Sensorvorrichtungen ausgegeben werden, nicht ausreichend übereinstimmen, kann die Sensorsteuerung daraus schließen, dass mindestens einer der beiden Messkanäle defekt ist.

Ausgehend von der Überlegung, dass typischerweise nicht beide Messkanäle gleichzeitig defekt werden, kann die Sensorsteuerung dafür vorbereitet sein, durch Einbeziehung zusätzlicher Informationen darauf zu schließen, welcher der beiden Messkanäle wahrscheinlich defekt ist. Die zusätzlichen Informationen können beispielsweise mittels des oben beschriebenen selektiven Aufschaltens von Testspannungen oder Testströmen auf Eingänge des ersten und/oder zweiten Analog-Digital-Wandlers gewonnen werden. Es hängt von der Anwendung ab, ob es im Fehlerfall besser ist, einen Notbetrieb mit einem vermutlich noch funktionsfähigen einzelnen Messkanal durchzuführen oder ob ein vollständiger Verzicht auf Strommesswerte weniger folgenreich ist.

Die Steuerverbindung kann zumindest abschnittsweise über einen Datenbus geführt sein, über den digitalisierte Messwerte von dem ersten Analog-Digital-Wandler zu der Sensorsteuerung übertragbar sind. Hierdurch ist eine zuverlässige, standardisierte Übertragung der Steuerdaten über einen Fahrzeugbus, beispielsweise über einen CAN-Bus, möglich. Hierdurch kann die Verwendung und/oder die Bereitstellung eines zweiten Datenbus für die Strommessung vermieden werden.

Die Sensorbaugruppe kann eine Anpassungseinheit zur Aufbereitung der von dem ersten Analog-Digital-Wandler bereitgestellten digitalen Messwerte für eine Übertragung über den Datenbus umfassen. Hierdurch kann für die Übermittlung der von dem ersten Analog-Digital-Wandler bereitgestellten Messwerte zur Sensorsteuerung ein im Fahrzeug ohnehin vorhandener Datenbus genutzt werden.

Die Anpassungseinheit kann die Sensorsteuerung umfassen. Durch Zusammenfassung von Anpassungseinheit und Sensorsteuerung in eine gemeinsame Baugruppe kann ein Herstellungs- und Wartungsaufwand für die Strommessschaltung verringert werden.

Die Sensorbaugruppe kann eine Anpassungseinheit zur Aufbereitung der von dem zweiten Analog-Digital-Wandler bereitgestellten digitalen Messwerte für eine Übertragung über den Datenbus umfassen. Hierdurch kann für die Übermittlung der von dem zweiten Analog-Digital-Wandler bereitgestellten Messwerte zur Sensorsteuerung ein im Fahrzeug ohnehin vorhandener Datenbus genutzt werden.

Die Anpassungseinheit kann einen Controller umfasst, der für eine zeitlich abwechselnde Aufbereitung der von dem ersten Analog-Digital-Wandler bereitgestellten digitalen Messwerte und der von dem zweiten Analog-Digital-Wandler bereitgestellten digitalen Messwerte nutzbar ist. Durch abwechselnde Nutzung desselben Controllers im Zeitteilungsverfahren für beide Analog-Digital-Wandler (beispielsweise mittels *Multitasking* oder *Multithreading*) kann ein Controller zur Aufbereitung der von dem zweiten Analog-Digital-Wandler bereitgestellten digitalen Messwerte eingespart werden.

Der erste Analog-Digital-Wandler kann Teil eines Mikrocontrollers der Sensorbaugruppe sein. Die Realisierung der Analog-Digital-Wandler-Funktion mittels eines Mikrocontrollers kann eine Anpassungsfähigkeit an neue Anforderungen und eine Einbeziehbarkeit weiterer Funktionalitäten verbessern.

Erfindungsgemäß ist das bekannte Verfahren zur Überwachung einer Funktionsfähigkeit einer Strommessschaltung dadurch weitergebildet, dass das Verfahren folgende Schritte umfasst: Bereitstellen einer Strommessschaltung, die einen ersten Analog-Digital-Wandler zur Wandlung von analogen Messwerten in digitalisierte Messwerte umfasst, wobei ein Eingang des ersten Analog-Digital-Wandlers mit einer ersten Eingangsleitung der Strommessschaltung über eine erste Vorschaltimpedanz verbunden ist; Beeinflussen des Eingangs des ersten Analog-Digital-Wandlers mittels Aufschalten einer Testspannung oder eines Teststroms auf den Eingang des ersten Analog-Digital-Wandlers; Erfassen eines Messwerts während des Beeinflussens des Eingangs des ersten Analog-Digital-Wandlers; und Bewerten einer Funktionsfähigkeit der Strommessschaltung mittels eines Vergleichs des erfassten Messwerts mit vorbestimmten Soll-Messergebnissen. Dadurch, dass der Eingang des ersten Analog-Digital-Wandlers mit einer ersten Eingangsleitung der Strommessschaltung über eine erste Vorschaltimpedanz verbunden ist, kann die Eingangsspannung des ersten Analog-Digital-Wandlers mittels der Testspannung oder des Teststroms gezielt beeinflusst werden. So kann die Funktionsfähigkeit der Strommessschaltung anhand beeinflussungsabhängiger Messwerte bewertet werden. Die gezielte Beeinflussung ermöglicht eine Korrelation zwischen der gezielten Beeinflussung und erfassten Messwerte. Anhand der Korrelation können aus den Messergebnissen Informationsanteile herausgefiltert werden, die eine Systemantwort der Strommessschaltung auf die gezielte Beeinflussung des Eingangs des ersten Analog-Digital-Wandlers darstellen.

Die Erfindung wird nachfolgend anhand von Ausführungsbeispielen näher erläutert, die in den schematischen Zeichnungen dargestellt sind. Es zeigen:

Fig. 1    ein schematisches Blockschaltbild einer Bordschaltung eines Kraftfahrzeugs;

Fig. 2    ein schematisches Blockschaltbild einer ersten Ausführungsform einer Strommessschaltung, die eine Sensorsteuerung und eine Steuerverbindung zur Beeinflussung einer Sensorvorrichtung mittels der Sensorsteuerung umfasst;

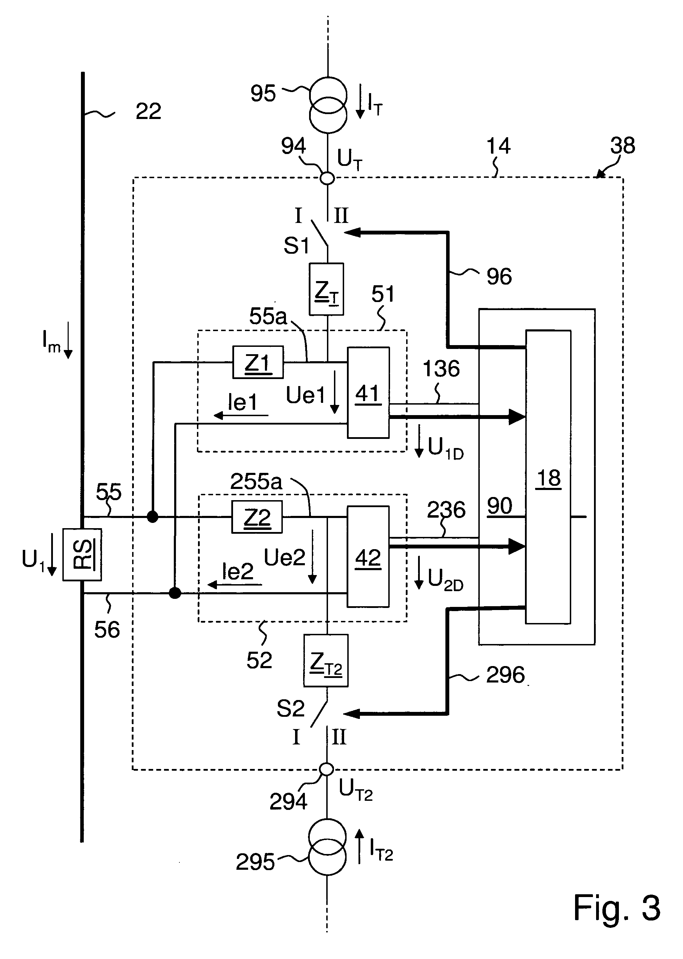

Fig. 3    ein schematisches Blockschaltbild einer zweiten Ausführungsform einer Strommessschaltung, die eine Sensorsteuerung und eine Steuerverbindung zur Beeinflussung einer Sensorvorrichtung mittels der Sensorsteuerung umfasst; und

Fig. 4    ein schematisches Ablaufdiagramm eines Verfahrens zur Überwachung einer Funktionsfähigkeit einer Strommessschaltung.

In den Figuren werden für entsprechende Komponenten jeweils dieselben Bezugszeichen verwendet. Bezugszeichenbezogene Erläuterungen gelten daher figurenübergreifend, sofern sich aus dem Zusammenhang nichts anderes ergibt.

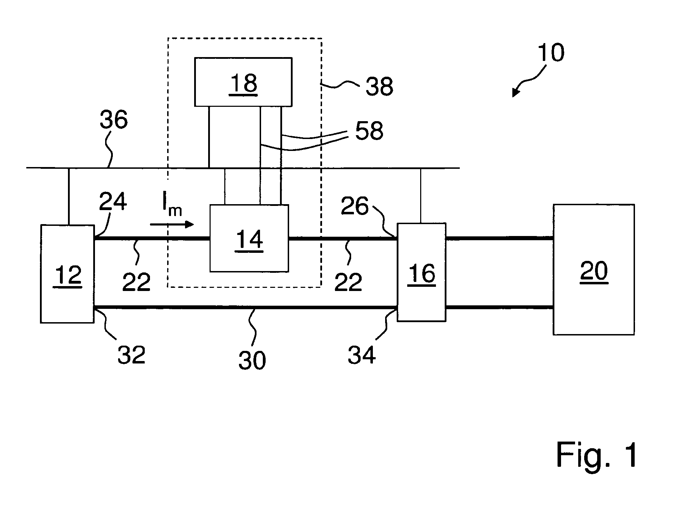

Die in Fig. 1 gezeigte Bordschaltung 10 eines Fahrzeugs, insbesondere Kraftfahrzeugs, umfasst eine Stromquelle 12 (beispielsweise eine Batterie, insbesondere eine wiederaufladbare Batterie und/oder eine Fahrzeugbatterie), eine Sensorbaugruppe 14, eine Stromversorgungstrennvorrichtung 16, eine Sensorsteuerung 18 und eine elektrische Last 20. Die elektrische Last 20 kann eine Vielzahl von Verbrauchern für elektrische Energie umfassen (beispielsweise Anlasser, Motorelektronik, Beleuchtung und Assistenzsysteme). Die Stromversorgungstrennvorrichtung 16 ist zweipolig in den Stromkreis zwischen Stromquelle 12 und der elektrischen Last 20 eingefügt. Die Sensorbaugruppe 14 ist in der Plusleitung 22 zwischen dem Plusanschluss 24 der Stromquelle 12 und dem Plusanschluss 26 der Stromversorgungstrennvorrichtung 16 angeordnet. Alternativ kann die Sensorbaugruppe 14 in der Minusleitung 30 zwischen dem Minusanschluss 32 der Stromquelle 12 und dem Minusanschluss 34 der Stromversorgungstrennvorrichtung 16 angeordnet sein. Die Sensorsteuerung 18 (beispielsweise in einem Stromversorgungssteuergerät oder in einem Batteriesteuergerät) ist mit der Stromquelle 12, der Sensorbaugruppe 14 und der Stromversorgungstrennvorrichtung 16 über einen Datenbus 36 (beispielsweise über einen CAN-Bus) verbunden. Die Sensorsteuerung 18 kann über den Datenbus 36 Messdaten von der Stromquelle 12 und der Sensorbaugruppe 14 empfangen. Die Sensorsteuerung 18 erhält über den Datenbus 36 beispielsweise aktuelle Temperaturmesswerte von der Stromquelle 12 und aktuelle Stromstärkemesswerte von der Sensorbaugruppe 14. In Abhängigkeit von diesen und/oder anderen Daten entscheidet die Sensorsteuerung 18, ob sie der Stromversorgungstrennvorrichtung 16 über den Datenbus 36 befiehlt, den Stromkreis zwischen der Stromquelle 12 und der elektrischen Last 20 zu öffnen oder zu schließen.

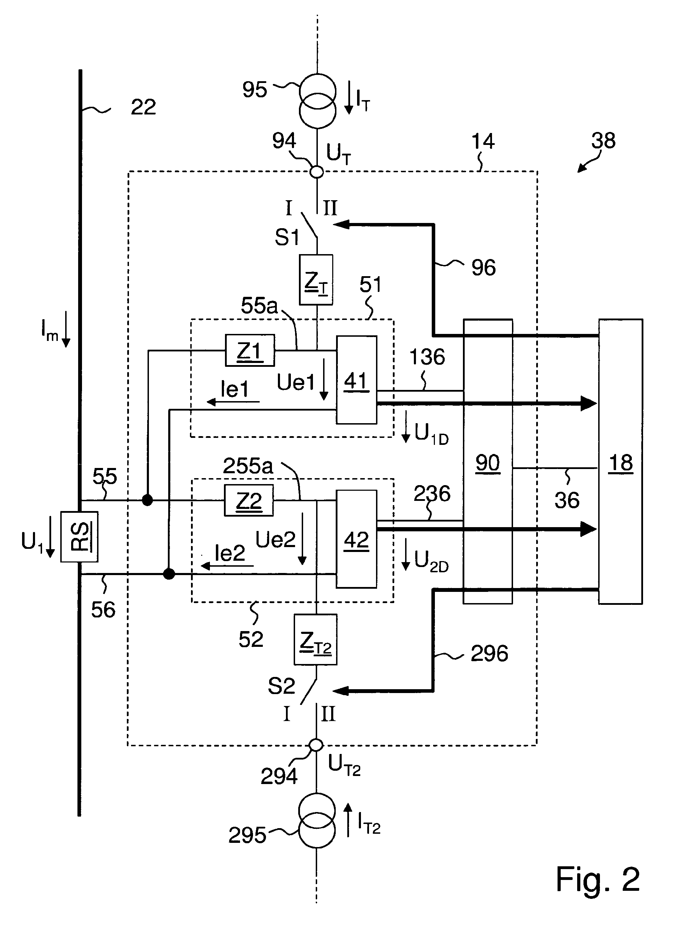

Die Fig. 2 zeigt eine erste Ausführungsform einer Strommessschaltung 38, die eine Sensorbaugruppe 14 und eine Steuerschaltung 18 umfasst. Die Steuerschaltung 18 umfasst zwei Sensorvorrichtungen 51, 52, die jeweils einen Spannungsabfall $U_1$ auswerten, der durch einen Strom $I_m$ verursacht wird, der durch einen Shunt RS fließt. Die erste Sensorvorrichtung 51 umfasst einen ersten Analog-Digital-Wandler 41, und die zweite Sensorvorrichtung 52 umfasst einen zweiten Analog-Digital-Wandler 42.

Zur Aufbereitung der von den Analog-Digital-Wandlern 41, 42 ausgegebenen digitalen Messwerte $U_{1D}$, $U_{2D}$ für eine Übertragung der digitalen Messwerte $U_{1D}$, $U_{2D}$ über einen Datenbus 36 zur Sensorsteuerung 18 ist eine Anpassungseinheit 90 vorgesehen. Die Anpassungseinheit 90 kann für jeden der beiden Analog-Digital-Wandler 41, 42 eine separate Anpassungseinheit, beispielsweise je einen Controller, umfassen. Es kann aber auch vorteilhaft sein, für beide Anpassungseinheiten einen gemeinsamen Controller zu nutzen. Der Controller kann für die Anwendung eines Zeitteilungsverfahrens vorbereitet sein, in welchem eine Prozessorleistung des gemeinsamen Controllers abwechselnd zur Anpassung der digitalen Messwerte $U_{1D}$ des ersten Analog-Digital-Wandlers 41 und zur Anpassung der digitalen Messwerte $U_{2D}$ des zweiten Analog-Digital-Wandlers 42 genutzt wird. Fettgezeichnete Pfeile in der Figur symbolisieren Verbindungen für Datenflüsse.

Da der Eingang 55a, 56 des ersten Analog-Digital-Wandlers 41 (beziehungsweise der Eingang 255a, 56 des zweiten Analog-Digital-Wandlers 42) ein Spannungsmesseingang ist, fließt im Normalbetrieb (im Nichtkurzschlussfall) nur ein Eingangsstrom mit einer sehr kleinen Stromstärke Ue1/Re1 (beziehungsweise Ue2/Re2) durch die Vorschaltimpedanz Z1 (beziehungsweise Z2). Mit der Vorschaltimpedanz Z1 (bzw. Z2) wird unter anderem verhindert, dass bei einem Kurzschluss des Eingangs 55a, 56 des Analog-Digital-Wandlers 41 (bzw. bei einem Kurzschluss des Eingangs 255a, 56 des Analog-Digital-Wandlers 42) der andere der beiden Analog-Digital-Wandler 41, 42 überhaupt keinen Spannungsabfall $U_1$ am Shunt RS mehr messen kann. Die Vorschaltimpedanz Z1 und/oder die Vorschaltimpedanz Z2 kann ein reiner Wirkwiderstand (d.h. ein Scheinwiderstand ohne Blindwiderstand) sein.

Darüberhinaus können die Vorschaltimpedanzen Z1 (bzw. Z2) die Aufgabe erfüllen, im Kurzschlussfall den Kurzschlussstrom durch die Sensorvorrichtung 51 (bzw. 52) zu begrenzen. Dazu sollte der Realteil der Impedanz der Vorschaltimpedanz Z1 (bzw. Z2) mindestens um den Faktor 10, insbesondere bevorzugt mindestens um den Faktor 30 oder 50, größer sein, als der Widerstandswert des Shunts RS.

Wenn der Spannungsabfall an der Vorschaltimpedanz Z1 (bzw. Z2) im Verhältnis zu dem Spannungsabfall an dem Eingangswiderstand Re1 (bzw. Re2) des Analog-Digital-Wandlers 41 (bzw. 42) gering ist, kann der Spannungsabfall an der Vorschaltimpedanz Z1 (bzw. Z2) bei der Auswertung der erfassten Spannungswerte Ue1 (bzw. Ue2) vernachlässigt werden. Dazu sollte der Betrag der Vorschaltimpedanz Z1 (bzw. Z2) mindestens um den Faktor 10, insbesondere bevorzugt mindestens um den Faktor 30 oder 50, kleiner sein, als der Eingangswiderstand Re1, Re2 des jeweiligen Analog-Digital-Wandlers 41, 42.

Durch Beachtung der Spannungsteilerregel kann der Spannungsabfall an der Vorschaltimpedanz Z1 (bzw. Z2) in der Auswertung berücksichtigt werden:

$$U_1 = Ue1\ (Z1 + Re1)\ /\ Re1 \quad \text{bzw.} \quad U_1 = Ue2\ (Z2 + Re2)\ /\ Re2 \quad \text{(Gleichung 1)}.$$

Voraussetzung dafür, dass $U_1$ mit ausreichender Genauigkeit ermittelt werden kann, ist, dass sowohl der Betrag der Vorschaltimpedanz Z1 (bzw. Z2) als auch der Widerstandswert des Eingangswiderstands Re1 (bzw. Re2) mit ausreichender Genauigkeit bekannt sind.

Die Strommessschaltung 38 umfasst einen Testreferenzeingang 94 zum Anlegen eines vordefinierten Testspannungspotentials $U_T$ aus einer in der Figur nicht dargestellten Testspannungsquelle und/oder zum Einprägen eines vordefinierten Teststroms $I_T$ aus einer Teststromquelle 95. Als Option umfasst die Strommessschaltung 38 einen zweiten Testreferenzeingang 294 zum Anlegen eines vordefinierten Testspannungspotentials $U_{T2}$ aus einer in der Figur nicht dargestellten zweiten Testspannungsquelle und/oder zum Einprägen eines vordefinierten Teststroms $I_{T2}$ aus einer zweiten Teststromquelle 295. Das Testspannungspotential $U_T$ (bzw. $U_{T2}$) kann jeweils ein Konstantspannungspotential oder ein Wechselspannungspotential sein. Entsprechend kann der Teststrom $I_T$ (bzw. $I_{T2}$) jeweils ein Konstantstrom oder ein Wechselstrom sein.

Der Eingang 55a des ersten Analog-Digital-Wandlers 41 der ersten Sensorvorrichtung 51 ist über eine Serienschaltung aus einer Aufschaltimpedanz $Z_T$ und einem ersten Schalter S1 mit dem Testreferenzeingang 94 verbunden. Wenn der erste Schalter S1 auf Stromdurchlass geschaltet ist, fließt folgender Eingangstrom Ie1 durch den Eingang des ersten Analog-Digital-Wandlers 41:

$$\text{Ie1} = U_1 / (Z1 + Re1) + U_T / (Z_T + Re1) \qquad \text{(Gleichung 2)}.$$

Hierbei wird unterstellt, dass Leitung 56 das Bezugspotential für die Spannung $U_T$ bereitstellt.

Die Eingangsspannung Ue1 des ersten Analog-Digital-Wandlers 41 beträgt somit:

$$\text{Ue1} = Re1\,(\,U_1 / (Z1 + Re1) + U_T / (Z_T + Re1)\,) = U_1 /(\,1 + Z1 / Re1) + U_T /(1 + Z_T / Re1).$$

Wenn die Testspannung $U_T$ und die Beträge der Impedanzen Re1, Z1 und $Z_T$ mit ausreichender Genauigkeit bekannt sind, kann die Steuerung 18 den Spannungsabfall $U_1$ an dem Shunt RS mittels Anwendung folgender Gleichung zurückrechnen:

$$U_1 = (\text{Ue1} - U_T /(1 + Z_T / Re1)) / (\,1 + Z1 / Re1) \qquad \text{(Gleichung 3)}.$$

Wenn statt einer Testspannungsquelle eine Teststromquelle 95 verwendet wird, lautet die entsprechende Beziehung wie folgt:

$$U_1 = \text{Ue1}\,(\,1 + Z1 / Re1) - Z1 * I_T \qquad \text{(Gleichung 4)}.$$

Die Verwendung einer Teststromquelle 95 vereinfacht den Selbsttest der Strommessschaltung 38 insofern, als dass bei Verwendung einer Teststromquelle 95 der Wert der Aufschaltimpedanz $Z_T$ nicht genau bekannt sein muss. Aus Gleichung 3 beziehungsweise 4 ist ersichtlich, dass die rückberechnete Spannung $U_1$ von der Testspannung $U_T$ beziehungsweise von dem Teststrom $I_T$ abhängt, wenn der erste Schalter S1 auf Stromdurchlass geschaltet ist. Die Aufschaltimpedanz $Z_T$ kann ein reiner Wirkwiderstand (d.h. ein Scheinwiderstand ohne Blindwiderstand) sein.

Zwischen der Sensorsteuerung 18 und dem ersten Schalter S1 ist eine Steuerverbindung 96 vorgesehen, mittels der die Sensorsteuerung 18 den ersten Schalter S1 betätigen kann. Hierdurch kann die Sensorsteuerung 18 an dem Eingang 55a des ersten Analog-Digital-Wandlers 41 einen definierten Betriebszustand II herbeiführen und mittels eines Vergleichs der Messergebnisse im Betriebszustand II mit vorbestimmten Messergebnissen auf die Funktionsfähigkeit der Sensorvorrichtungen 51, 52 rückschließen. Der Betriebszustand I bezeichnet einen Betriebszustand ohne Testaufschaltung. Die Sensorsteuerung 18 kann aus den Messergebnissen $U_{1D}$ Informationsanteile herausfiltern, die eine Systemantwort der Strommessschaltung 38 auf die gezielte Beeinflussung des Eingangs 55a des ersten Analog-Digital-Wandlers 41 darstellen.

Zur gezielten Beeinflussung kann als Testspannungs- oder Teststromquelle 95 eine Gleichspannungs- beziehungsweise Gleichstromquelle verwendet werden. Alternativ kann zur gezielten Beeinflussung als Testspannungs- oder Teststromquelle 95 eine Wechselspannungsbeziehungsweise Wechselstromquelle verwendet werden, deren zeitlicher Spannungs- bzw. Stromverlauf und/oder Frequenzspektrum vorbestimmt (vorzugsweise stationär) ist. Beispielsweise kann die Wechselspannungs- oder Wechselstromquelle eine (vorzugsweise nullpunktfreie) periodische Spannung $U_T$ beziehungsweise einen (vorzugsweise nullpunktfreien) periodischen Strom $I_T$ bereitstellen. Die Spannung UT kann beispielsweise eine Dreieckspannung oder eine Sinusspannung sein; und der Strom IT kann beispielsweise ein Strom sein, dessen Amplitude zeitlich sinus- oder dreieckförmig verläuft. Die Sensorsteuerung 18 kann am Ende der Messkette 51, 90, 36, 18 diejenigen Wechselspannungsanteile aus dem Messsignal $U_{1D}$ herausfiltern, zu denen am Eingang 55a des ersten Analog-Digital-Wandlers 41 die Testspannungs- beziehungsweise Teststromquelle 95 beigetragen hat. Vorzugsweise enthält die gezielte Beeinflussung (durch die Testspannungs- oder Teststromquelle 95) Frequenzanteile in einem Frequenzbereich, die der auf dem Leiter 22 zu messende Strom $I_m$ nicht enthält oder von der Strommessschaltung 38 spezifikationsgemäß nicht gemessen werden sollen.

Um zu verhindern, dass die Testspannungs- beziehungsweise Teststromquelle 95 auf dem Leiter 22 eine unzulässige Störspannung verursacht, kann die erste Vorschaltimpedanz Z1 ein Filter (vorzugsweise ein Frequenzfilter, insbesondere bevorzugt ein Bandfilter oder einen Tiefpass umfassen) umfassen. Alternativ oder zusätzlich kann die Strommessfunktion der Strommessschaltung 38 von der Selbsttestfunktion der Strommessschaltung 38 dadurch entkoppelt werden, dass der Selbsttest nur in Betriebszuständen der Fahrzeugelektronik durchgeführt, in denen die Funktion der Fahrzeugelektronik dadurch nicht beeinträchtigt wird.

Eine Weiterbildung sieht vor, dass die Bewertung der Funktionsfähigkeit der Strommessschaltung 38 auch unter Berücksichtigung von Messwerten $U_{2D}$ durchführbar ist, die von der zweiten Sensorvorrichtung 52 erfassbar sind. Wenn digitalisierte Messwerte $U_{1D}$, $U_{2D}$, die von den beiden Sensorvorrichtungen 51, 52 ausgegeben werden, nicht ausreichend übereinstimmen, kann die Sensorsteuerung 18 daraus schließen, dass mindestens einer der beiden Messkanäle defekt ist. Ausgehend von der Überlegung, dass typischerweise nicht beide Messkanäle gleichzeitig defekt werden, kann die Sensorsteuerung 18 dafür vorbereitet sein, durch Einbeziehung zusätzlicher Informationen darauf zu schließen, welcher der beiden Messkanäle wahrscheinlich defekt ist. Die zusätzlichen Informationen können beispielsweise mittels des oben beschriebenen selektiven Aufschaltens von Testspannungen $U_T$, $U_{T2}$ oder Testströmen $I_T$, $I_{T2}$ auf Eingänge des ersten 41 und/oder zweiten 42 Analog-Digital-Wandlers gewonnen werden. Es hängt von der Anwendung ab, ob es im Fehlerfall besser ist, einen Notbetrieb nur mit einem einzelnen vermutlich noch funktionsfähigen Messkanal durchzuführen oder ob ein vollständiger Verzicht auf Messwerte $U_{1D}$, $U_{2D}$ für den zu messenden Strom $I_m$ weniger folgenreich ist.

Falls die Strommessschaltung 38 einen zweiten Testreferenzeingang 294 umfasst, ist der Eingang 255a des zweiten Analog-Digital-Wandlers 42 der zweiten Sensorvorrichtung 52 über eine Serienschaltung aus einer Aufschaltimpedanz $Z_{T2}$ und einem zweiten Schalter S2 mit dem Testreferenzeingang 294 verbunden. Zwischen der Sensorsteuerung 18 und dem zweiten Schalter S2 ist dann eine Steuerverbindung 296 vorgesehen, mittels der die Sensorsteuerung 18 den zweiten Schalter S2 betätigen kann. Hierdurch kann die Sensorsteuerung 18 auch an dem Eingang 255a des zweiten Analog-Digital-Wandlers 41 einen definierten Betriebszustand II herbeiführen und mittels eines Vergleichs der Messergebnisse im Betriebszustand II mit vorbestimmten Messergebnissen auf die Funktionsfähigkeit der Sensorvorrichtungen 51, 52 rückschließen. Die Sensorsteuerung 18 kann aus den Messergebnissen $U_{2D}$ Informationsanteile herausfiltern, die eine Systemantwort der Strommessschaltung 38 auf die gezielte Beeinflussung des Eingangs 255a des zweiten Analog-Digital-Wandlers 42 darstellen. Die Aufschaltimpedanz $Z_{T2}$ kann ein reiner Wirkwiderstand (d.h. ein Scheinwiderstand ohne Blindwiderstand) sein.

Zur gezielten Beeinflussung kann als Testspannungs- oder Teststromquelle 95 eine Gleichspannungs- beziehungsweise Gleichstromquelle verwendet werden. Alternativ kann zur gezielten Beeinflussung als Testspannungs- oder Teststromquelle 95 eine Wechselspannungsbeziehungsweise Wechselstromquelle verwendet werden, deren zeitlicher Spannungs- bzw. Stromverlauf und/oder Frequenzspektrum vorbestimmt (vorzugsweise stationär) ist. Beispielsweise kann die Wechselspannungs- oder Wechselstromquelle eine (vorzugsweise nullpunktfreie) periodische Spannung $U_T$ beziehungsweise einen (vorzugsweise nullpunktfreien) periodischen Strom $I_T$ bereitstellen. Die Spannung UT kann beispielsweise eine Dreieckspannung oder eine Sinusspannung sein; und der Strom IT kann beispielsweise ein Strom sein, dessen Amplitude zeitlich sinus- oder dreieckförmig verläuft. Die Sensorsteuerung 18 kann am Ende der Messkette 51, 90, 36, 18 diejenigen Wechselspannungsanteile aus dem Messsignal $U_{1D}$ herausfiltern, zu denen am Eingang 55a des ersten Analog-Digital-Wandlers 41 die Testspannungs- beziehungsweise Teststromquelle 95 beigetragen hat. Vorzugsweise enthält die gezielte Beeinflussung (durch die Testspannungs- oder Teststromquelle 95) Frequenzanteile in einem Frequenzbereich, die der auf dem Leiter 22 zu messende Strom $I_m$ nicht enthält oder von der Strommessschaltung 38 spezifikationsgemäß nicht gemessen werden sollen.

Um zu verhindern, dass die Testspannungs- beziehungsweise Teststromquelle 95 auf dem Leiter 22 eine unzulässige Störspannung verursacht, kann die erste Vorschaltimpedanz Z1 ein Filter (vorzugsweise ein Frequenzfilter, insbesondere bevorzugt ein Bandfilter oder einen Tiefpass umfassen) umfassen. Alternativ oder zusätzlich kann die Strommessfunktion der Strommessschaltung 38 von der Selbsttestfunktion der Strommessschaltung 38 dadurch entkoppelt werden, dass der Selbsttest nur in Betriebszuständen der Fahrzeugelektronik durchgeführt, in denen die Funktion der Fahrzeugelektronik dadurch nicht beeinträchtigt wird.

Eine Weiterbildung sieht vor, dass die Bewertung der Funktionsfähigkeit der Strommessschaltung 38 auch unter Berücksichtigung von Messwerten $U_{2D}$ durchführbar ist, die von der zweiten Sensorvorrichtung 52 erfassbar sind.

Eine Nutzung des optionalen zweiten Testreferenzeingangs 294 kann dazu beitragen, eine Verfügbarkeit der Überwachung der Strommessschaltung 38 für den Fall zu verbessern, dass eine Funktion des ersten Testreferenzeingangs 94 ausfällt. Unabhängig davon kann eine Nutzung des optionalen zweiten Testreferenzeingangs 294 dazu beitragen, eine Zuverlässigkeit und/oder Aussagekraft der Überwachung der Funktionsfähigkeit der Strommessschaltung 38 zu erhöhen. Mittels des optionalen zweiten Testreferenzeingangs 294 kann beispielsweise ein Übersprechen (*crosstalk*) von dem Spannungsmesseingang 255a des zweiten Analog-Digital-Wandlers 42 zu dem Spannungsmesseingang 55a des ersten Analog-Digital-Wandlers 41 ausgetestet und erkannt werden.

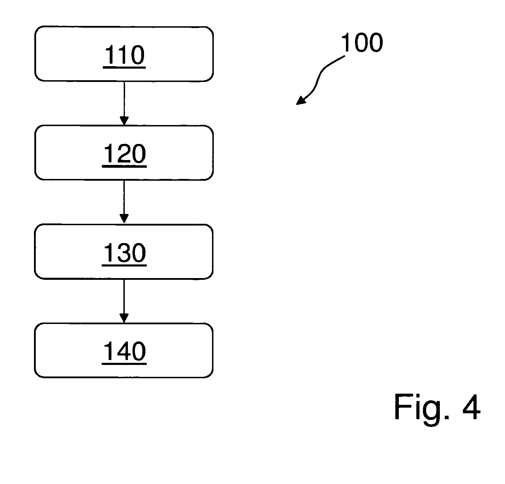

Das in Fig. 4 dargestellte Verfahren 100 zur Überwachung einer Funktionsfähigkeit einer Strommessschaltung 38 umfasst folgende Schritte 110, 120, 130, 140. In einem ersten Schritt 110 wird eine Strommessschaltung 38 bereitgestellt, die einen ersten Analog-Digital-Wandler 41 zur Wandlung von analogen Messwerten in digitalisierte Messwerte $U_{1D}$ umfasst. Hierbei ist ein Eingang 55a des ersten Analog-Digital-Wandlers 41 mit einer ersten Eingangsleitung 55

der Strommessschaltung 14 über eine erste Vorschaltimpedanz Z1 verbunden. In einem zweiten Schritt 120 wird ein Eingang 55a des ersten Analog-Digital-Wandlers 41 mittels Aufschalten einer Testspannung $U_T$ oder eines Teststroms $I_T$ auf den Eingang 55a des ersten Analog-Digital-Wandlers 41 beeinflusst. In einem dritten Schritt 130 wird während des Beeinflussens des Eingangs 55a des ersten Analog-Digital-Wandlers 41 ein digitaler Messwert $U_{1D}$ erfasst. In einem vierten Schritt 140 wird eine Funktionsfähigkeit der Strommessschaltung 38 mittels eines Vergleichs des erfassten digitalen Messwerts $U_{1D}$ mit vorbestimmten Soll-Messergebnissen bewertet.

Die beschriebenen Schaltungsprinzipien können auch mit umgekehrter Polung angewendet werden. Analoge und/oder digitale elektrische Signale, die in den Ausführungsbeispielen in Gestalt von Spannungen dargestellt sind, können alternativ oder zusätzlich auch als (eingeprägte) Ströme dargestellt werden. Mittels Verstärkern oder Wandlern können in der Beschreibung erwähnte Spannungen oder Ströme auf dem Weg von ihrer jeweiligen Quelle zu ihrer jeweiligen Senke umskaliert werden. Analoge oder digitale Signale, die in Gestalt von Spannungen oder Strömen dargestellt sind, können nach einem bekannten oder nach einem heute noch nicht bekannten Verfahren linear oder nichtlinear codiert sein. Beispiele für anwendbare Codierungsverfahren sind Pulsweitenmodulation und Pulscodemodulation. Die analogen und/oder digitalen Signale können elektrisch, optisch oder per Funk übertragen werden. Die analogen und/oder digitalen Signale können im Raummultiplex (also mittels unterschiedlicher Leitungen), im Zeitmultiplex oder im Codemultiplex übertragen werden. Die Übertragung der analogen und digitalen Signale kann über ein oder mehrere Bussysteme erfolgen.

**Bezugszeichen:**

| | |
|---|---|
| 10 | Bordschaltung |
| 12 | Stromquelle; Fahrzeugbatterie |
| 14 | Sensorbaugruppe |
| 16 | Stromversorgungstrennvorrichtung |
| 18 | Sensorsteuerung |
| 20 | elektrische Last |
| 22 | Leiter; Plusleitung |
| 24 | Plusanschluss der Stromquelle |
| 26 | Plusanschluss der Stromversorgungstrennvorrichtung |
| 30 | Minusleitung |
| 32 | Minusanschluss der Stromquelle |
| 34 | Minusanschluss der Stromversorgungstrennvorrichtung |
| 36 | Datenleitung; Datenbus; CAN-Bus |
| 38 | Strommessschaltung |
| 41 | erster Analog-Digital-Wandler |
| 42 | zweiter Analog-Digital-Wandler |
| 51 | erste Sensorvorrichtung |
| 52 | zweite Sensorvorrichtung |
| 55 | erster Abgriff an der Plusleitung |
| 55a | Spannungsmesseingang des ersten Analog-Digital-Wandlers |
| 56 | zweiter Abgriff an der Plusleitung |
| 90 | Anpassungseinheit |
| 94 | Testreferenzeingang |
| 95 | Teststromquelle |
| 96 | Steuerverbindung |
| 100 | Verfahren zur Überwachung einer Funktionsfähigkeit einer Strommessschaltung |
| 110 | Bereitstellen einer Strommessschaltung |
| 120 | Beeinflussen eines Eingangs des ersten A/D-Wandlers |
| 130 | Erfassen eines Messwerts |
| 140 | Bewertung einer Funktionsfähigkeit der Strommessschaltung |
| 236 | Datenleitung; Datenbus für zweiten Analog-Digital-Wandler |
| 255a | Spannungsmesseingang des zweiten Analog-Digital-Wandlers |
| 294 | zweiter Testreferenzeingang |
| 295 | zweite Teststromquelle |
| 296 | zweite Steuerverbindung |
| I | Betriebszustand ohne Testaufschaltung |

| II | Betriebszustand mit Testaufschaltung |
|---|---|
| $I_m$ | zu messender Strom |
| $I_T$ | Teststrom durch ersten Testreferenzeingang |
| $I_{T2}$ | Teststrom durch zweiten Testreferenzeingang |
| Re1 | Eingangswiderstand des ersten Analog-Digital-Wandlers |
| Re2 | Eingangswiderstand des zweiten Analog-Digital-Wandlers |
| RS | Shunt |
| S1 | erster Schalter; erste Beeinflussungsvorrichtung |
| S2 | zweiter Schalter; zweite Beeinflussungsvorrichtung |
| $U_1$ | Eingangsspannung |
| $U_{1D}$ | digitalisierter Messwert der ersten Sensorvorrichtung |
| $U_{2D}$ | digitalisierter Messwert der zweiten Sensorvorrichtung |
| $U_{e1}$ | analoger Messwert; Eingangsspannung des ersten Analog-Digital-Wandlers 41 |
| $U_{e2}$ | Eingangsspannung des zweiten Analog-Digital-Wandlers 42 |
| $U_T$ | Testspannung an erstem Testreferenzeingang |
| $U_{T2}$ | Testspannung an zweitem Testreferenzeingang |
| Z1 | erste Vorschaltimpedanz |
| Z2 | zweite Vorschaltimpedanz |
| $Z_T$ | Aufschaltimpedanz des ersten Testreferenzeingangs |
| $Z_{T2}$ | Aufschaltimpedanz des zweiten Testreferenzeingangs |

## Patentansprüche

**1.** Strommessschaltung (38), umfassend eine Sensorbaugruppe (14) zur Messung eines durch einen Leiter (22) fließenden elektrischen Stroms ($I_m$) mittels Messung einer Eingangsspannung ($U_1$) zwischen einer ersten (55) und einer zweiten (56) Eingangsleitung der Sensorbaugruppe (14) und eine Sensorsteuerung (18) zur Steuerung der Sensorbaugruppe (14), wobei die Sensorbaugruppe (14) eine erste Sensorvorrichtung (51) zur Erfassung der Stärke des elektrischen Stroms ($I_m$) mittels eines ersten Analog-Digital-Wandlers (41) zur Wandlung von analogen Messwerten ($U_{e1}$) in digitalisierte Messwerte ($U_{1D}$) umfasst und die Strommessschaltung (38) eine Beeinflussungsvorrichtung (S1) zur veränderlichen Aufschaltung einer Testspannung ($U_T$) oder eines Teststroms ($I_T$) auf einen Eingang (55a) des ersten Analog-Digital-Wandlers (41) umfasst, **dadurch gekennzeichnet, dass** der Eingang (55a) des ersten Analog-Digital-Wandlers (41) mit der ersten Eingangsleitung (55) der Sensorbaugruppe (14) über eine erste Vorschaltimpedanz (Z1) verbunden ist, wobei die Sensorsteuerung (18) dazu vorbereitet ist, an einem Eingang (55a) des ersten Analog-Digital-Wandlers (41) einen definierten Betriebszustand (II) herbeizuführen und mittels eines Vergleichs der digitalen Messwerte ($U_{1D}$) im definierten Betriebszustand (II) mit vorbestimmten Soll-Messergebnissen eine Funktionsfähigkeit der Strommessschaltung (38) zu bewerten.

**2.** Strommessschaltung (38) nach Anspruch 1, **dadurch gekennzeichnet, dass** die Strommessschaltung (38) einen Testreferenzeingang (94) zum Anschluss einer Teststromquelle (95) zum Bereitstellen des Teststroms ($I_T$) oder zum Anschluss einer Testspannungsquelle zum Bereitstellen der Testspannung ($U_T$) umfasst, insbesondere wobei ein Bezugspotentialanschluss (56) der Testspannungsquelle mit einem Bezugspotentialanschluss des ersten Analog-Digital-Wandlers (41) elektrisch verbunden ist.

**3.** Strommessschaltung (38) nach Anspruch 1 oder 2, **dadurch gekennzeichnet, dass** die Strommessschaltung (38) eine Steuerverbindung (96) umfasst, mittels der die veränderliche Aufschaltung der Testspannung ($U_T$) oder des Teststroms ($I_T$) durch die Sensorsteuerung (18) steuerbar ist.

**4.** Strommessschaltung (38) nach einem der Ansprüche 1 bis 3, **dadurch gekennzeichnet, dass** die Sensorbaugruppe (14) eine erste Sensorvorrichtung (51) zur Erfassung der Eingangsspannung ($U_1$) und eine zweite Sensorvorrichtung (52) zur Erfassung der Eingangsspannung ($U_1$) umfasst, wobei beide Sensorvorrichtungen (51, 52) einen gemeinsamen Messbereich aufweisen.

**5.** Strommessschaltung (38) nach einem der Ansprüche 1 bis 4, **dadurch gekennzeichnet, dass** die Sensorsteuerung (18) dazu vorbereitet ist, die Bewertung der Funktionsfähigkeit der Strommessschaltung (38) auch unter Berücksichtigung von digitalen Messwerten ($U_{2D}$) durchzuführen, die von der zweiten Sensorvorrichtung (52) erfassbar sind.

**6.** Strommessschaltung (38) nach einem der Ansprüche 1 bis 5, **dadurch gekennzeichnet, dass** die Steuerverbindung (96) zumindest abschnittsweise über einen Datenbus (36) geführt ist, über den digitalisierte Messwerte ($U_{1D}$) von dem ersten Analog-Digital-Wandler (41) zu der Sensorsteuerung (18) übertragbar sind.

7. Strommessschaltung (38) nach einem der Ansprüche 1 bis 6, **dadurch gekennzeichnet, dass** die Sensorbaugruppe (14) eine Anpassungseinheit (90) zur Aufbereitung der von dem ersten Analog-Digital-Wandler (41) bereitgestellten digitalen Messwerte ($U_{1D}$) für eine Übertragung über den Datenbus (36) umfasst.

8. Strommessschaltung (38) nach Anspruch 7, **dadurch gekennzeichnet, dass** die Anpassungseinheit (90) die Sensorsteuerung (18) umfasst.

9. Strommessschaltung (38) nach Anspruch 7 oder 8, **dadurch gekennzeichnet, dass** die Sensorbaugruppe (14) eine Anpassungseinheit (90) zur Aufbereitung der von dem zweiten Analog-Digital-Wandler (42) bereitgestellten digitalen Messwerte ($U_{2D}$) für eine Übertragung über den Datenbus (36) umfasst.

10. Strommessschaltung (38) nach Anspruch 9, **dadurch gekennzeichnet, dass** die Anpassungseinheit (90) einen Controller umfasst, der für eine zeitlich abwechselnde Aufbereitung der von dem ersten Analog-Digital-Wandler (41) bereitgestellten digitalen Messwerte ($U_{1D}$) und der von dem zweiten Analog-Digital-Wandler (42) bereitgestellten digitalen Messwerte ($U_{2D}$) nutzbar ist.

11. Strommessschaltung (38) nach einem der Ansprüche 1 bis 10, **dadurch gekennzeichnet, dass** der erste Analog-Digital-Wandler (41) Teil eines Mikrocontrollers der Sensorbaugruppe (14) ist.

12. Verfahren (100) zur Überwachung einer Funktionsfähigkeit einer Strommessschaltung (38), wobei das Verfahren (100) folgende Schritte (110, 120, 130) umfasst:

- Bereitstellen (110) einer Strommessschaltung (38), die einen ersten Analog-Digital-Wandler (41) zur Wandlung von analogen Messwerten in digitalisierte Messwerte ($U_{1D}$) umfasst, wobei ein Eingang (55a) des ersten Analog-Digital-Wandlers (41) mit einer ersten Eingangsleitung (55) der Strommessschaltung (14) über eine erste Vorschaltimpedanz (Z1) verbunden ist;
- Beeinflussen (120) des Eingangs (55a) des ersten Analog-Digital-Wandlers (41) mittels Aufschalten einer Testspannung ($U_T$) oder eines Teststroms ($I_T$) auf den Eingang (55a) des ersten Analog-Digital-Wandlers (41);
- Erfassen (130) eines Messwerts ($U_{1D}$) während des Beeinflussens des Eingangs (55a) des ersten Analog-Digital-Wandlers (41); und
- Bewerten (140) einer Funktionsfähigkeit der Strommessschaltung (38) mittels eines Vergleichs des erfassten Messwerts ($U_{1D}$) mit vorbestimmten Soll-Messergebnissen.

**Claims**

1. Current measuring circuit (38) comprising a sensor assembly (14) for measuring an electrical current ($I_m$) flowing through a conductor (22) by measuring an input voltage ($U_1$) between a first input line (55) and a second input line (56) of the sensor assembly (14) and a sensor control system (18) for controlling the sensor assembly (14), the sensor assembly (14) comprising a first sensor apparatus (51) for recording the intensity of the electrical current ($I_m$) using a first analogue/digital converter (41) for converting analogue measured values ($U_{e1}$) into digitized measured values ($U_{1D}$), and the current measuring circuit (38) comprising an influencing apparatus (S1) for variably connecting a test voltage ($U_T$) or a test current ($I_T$) to an input (55a) of the first analogue/digital converter (41), **characterized in that** the input (55a) of the first analogue/digital converter (41) is connected to the first input line (55) of the sensor assembly (14) via a first ballast impedance (Z1), the sensor control system (18) being prepared to cause a defined operating state (II) at an input (55a) of the first analogue/digital converter (41) and to assess the correct operation of the current measuring circuit (38) by comparing the digital measured values ($U_{1D}$) in the defined operating state (II) with predetermined desired measurement results.

2. Current measuring circuit (38) according to Claim 1, **characterized in that** the current measuring circuit (38) comprises a test reference input (94) for connecting a test current source (95) for providing the test current ($I_T$) or for connecting a test voltage source for providing the test voltage ($U_T$), a reference potential connection (56) of the test voltage source being electrically connected, in particular, to a reference potential connection of the first analogue/digital converter (41).

3. Current measuring circuit (38) according to Claim 1 or 2, **characterized in that** the current measuring circuit (38) comprises a control connection (96) which can be used by the sensor control system (18) to control the variable connection of the test voltage ($U_T$) or the test current ($I_T$).

4. Current measuring circuit (38) according to one of Claims 1 to 3, **characterized in that** the sensor assembly (14) comprises a first sensor apparatus (51) for recording the input voltage ($U_1$) and a second sensor apparatus (52) for recording the input voltage ($U_1$), both sensor apparatuses (51, 52) having a common measurement range.

5. Current measuring circuit (38) according to one of Claims 1 to 4, **characterized in that** the sensor control system (18) is prepared to assess the correct operation of the current measuring circuit (38) even taking into account digital measured values ($U_{2D}$) which can be recorded by the second sensor apparatus (52).

6. Current measuring circuit (38) according to one of Claims 1 to 5, **characterized in that** at least sections of the control connection (96) are routed via a data bus (36) which can be used to transmit digitized measured values ($U_{1D}$) from the first analogue/digital converter (41) to the sensor control system (18).

7. Current measuring circuit (38) according to one of Claims 1 to 6, **characterized in that** the sensor assembly (14) comprises a matching unit (90) for preprocessing the digital measured values ($U_{1D}$), provided by the first analogue/digital converter (41), for transmission via the data bus (36).

8. Current measuring circuit (38) according to Claim 7, **characterized in that** the matching unit (90) comprises the sensor control system (18).

9. Current measuring circuit (38) according to Claim 7 or 8, **characterized in that** the sensor assembly (14) comprises a matching unit (90) for preprocessing the digital measured values ($U_{2D}$), provided by the second analogue/digital converter (42), for transmission via the data bus (36).

10. Current measuring circuit (38) according to Claim 9, **characterized in that** the matching unit (90) comprises a controller for alternately preprocessing the digital measured values ($U_{1D}$) provided by the first analogue/digital converter (41) and the digital measured values ($U_{2D}$) provided by the second analogue/digital converter (42) in terms of time.

11. Current measuring circuit (38) according to one of Claims 1 to 10, **characterized in that** the first analogue/digital converter (41) is part of a microcontroller of the sensor assembly (14).

12. Method (100) for monitoring the correct operation of a current measuring circuit (38), the method (100) comprising the following steps (110, 120, 130) :

> - providing (110) a current measuring circuit (38) which comprises a first analogue/digital converter (41) for converting analogue measured values into digitized measured values ($U_{1D}$),
> an input (55a) of the first analogue/digital converter (41) being connected to a first input line (55) of the current measuring circuit (14) via a first ballast impedance (Z1);
> - influencing (120) the input (55a) of the first analogue/digital converter (41) by connecting a test voltage ($U_T$) or a test current ($I_T$) to the input (55a) of the first analogue/digital converter (41);
> - recording (130) a measured value ($U_{1D}$) while influencing the input (55a) of the first analogue/digital converter (41); and
> - assessing (140) the correct operation of the current measuring circuit (38) by comparing the recorded measured value ($U_{1D}$) with predetermined desired measurement results.

**Revendications**

1. Circuit (38) de mesure de courant comprenant
un module de capteur (14) qui mesure un courant électrique ($I_m$) qui s'écoule dans un conducteur (22) au moyen de la mesure de la tension d'entrée ($U_1$) entre un premier conducteur d'entrée (55) et un deuxième conducteur d'entrée (56) du module de capteur (14) et
une commande de capteur (18) qui commande le module de capteur (14),
le module de capteur (14) comprenant un premier dispositif de capteur (51) qui saisit l'intensité du courant électrique

($I_m$) au moyen d'un premier convertisseur analogique-numérique (41) qui convertit des valeurs analogiques de mesure ($U_{e1}$) en valeurs de mesure numériques ($U_{1D}$),
le circuit (38) de mesure de courant présentant un dispositif (S1) qui agit sur l'application variable d'une tension de test ($U_T$) ou d'un courant de test ($I_T$) sur une entrée (55a) du premier convertisseur analogique-numérique (41),
**caractérisé en ce que**
l'entrée (55a) du premier convertisseur analogique-numérique (41) est raccordée au premier conducteur d'entrée (55) du module de capteur (14) par l'intermédiaire d'une première impédance de prébranchement (Z1),
**en ce que** la commande de capteur (18) est prévue pour établir un état de fonctionnement (II) défini à une entrée (55a) du premier convertisseur analogique-numérique (41) et pour évaluer le bon fonctionnement du circuit (38) de mesure de courant au moyen d'une comparaison entre les valeurs numériques de mesure ($U_{1D}$) obtenues dans l'état de fonctionnement (II) défini à des résultats prédéterminés de mesure de consigne.

2. Circuit (38) de mesure de courant selon la revendication 1, **caractérisé en ce que** le circuit (38) de mesure de courant comporte une entrée (94) de référence de test destinée à être raccordée à une source (95) de courant de test qui délivre le courant de test ($I_T$) ou à la borne de raccordement d'une source de tension de test qui délivre la tension de test ($U_T$) et **en ce qu'**en particulier une borne (56) de potentiel de référence de la source de tension de test est reliée électriquement à une borne de potentiel de référence du premier convertisseur analogique-numérique (41).

3. Circuit (38) de mesure de courant selon les revendications 1 ou 2, **caractérisé en ce que** le circuit (38) de mesure de courant comporte une liaison de commande (96) au moyen de laquelle le branchement modifiable de la tension de test ($U_T$) ou du courant de test ($I_T$) peut être commandé par la commande de capteur (18).

4. Circuit (38) de mesure de courant selon l'une des revendications 1 à 3, **caractérisé en ce que** le module de capteur (14) comporte un premier dispositif de capteur (51) qui saisit la tension d'entrée ($U_1$) et un deuxième dispositif de capteur (52) qui saisit la tension d'entrée ($U_1$), les deux dispositifs de capteur (51, 52) présentant une plage de mesures commune.

5. Circuit (38) de mesure de courant selon l'une des revendications 1 à 4, **caractérisé en ce que** la commande de capteur (18) est prévue pour réaliser l'évaluation du bon fonctionnement du circuit (38) de mesure de courant en tenant compte également de valeurs de mesure numériques ($U_{2D}$) qui peuvent être saisies par le deuxième dispositif de capteur (52).

6. Circuit (38) de mesure de courant selon l'une des revendications 1 à 5, **caractérisé en ce que** la liaison de commande (96) est réalisée au moins en partie par un bus de données (36) qui permet de transférer les valeurs de mesure numérisées ($U_{1D}$) du premier convertisseur analogique-numérique (41) vers la commande de capteur (18).

7. Circuit (38) de mesure de courant selon l'une des revendications 1 à 6, **caractérisé en ce que** le module de capteur (14) comporte une unité d'adaptation (90) qui prépare les valeurs numériques de mesure ($U_{1D}$) délivrées par le premier convertisseur analogique-numérique (41) en vue de leur transfert sur le bus de données (36).

8. Circuit (38) de mesure de courant selon la revendication 7, **caractérisé en ce que** l'unité d'adaptation (90) comporte la commande de capteur (18).

9. Circuit (38) de mesure de courant selon les revendications 7 ou 8, **caractérisé en ce que** le module de capteur (14) présente une unité d'adaptation (90) qui prépare les valeurs de mesure numériques ($U_{2D}$) délivrées par le deuxième convertisseur analogique-numérique (42) en vue de leur transfert sur le bus de données (36).

10. Circuit (38) de mesure de courant selon la revendication 9, **caractérisé en ce que** l'unité d'adaptation (90) comporte un contrôleur qui peut être utilisé pour préparer en alternance dans le temps les valeurs de mesure numériques ($U_{1D}$) délivrées par le premier convertisseur analogique-numérique (41) et les valeurs de mesure numériques ($U_{2D}$) délivrées par le deuxième convertisseur analogique-numérique (42).

11. Circuit (38) de mesure de courant selon les revendications 1 à 10, **caractérisé en ce que** le premier convertisseur analogique-numérique (41) est un microcontrôleur du module de capteur (14).

12. Procédé (100) de surveillance du bon fonctionnement d'un circuit (38) de mesure de courant, le procédé (100) comportant les étapes (110, 120, 130) suivantes :

prévoir (110) un circuit (38) de mesure de courant qui comporte un premier convertisseur analogique-numérique (41) qui convertit des valeurs de mesure analogiques en valeurs de mesure numériques ($U_{1D}$), une entrée (55a) du premier convertisseur analogique-numérique (41) étant raccordée à un premier conducteur d'entrée (55) du circuit (14) de mesure de courant par l'intermédiaire d'une première impédance de pré-branchement (Z1),

agir (120) sur l'entrée (55a) du premier convertisseur analogique-numérique (41) par application d'une tension de test ($U_T$) ou d'un courant de test ($I_T$) sur l'entrée (55a) du premier convertisseur analogique-numérique (41),

saisir (130) une valeur de mesure ($U_{1D}$) pendant l'action sur l'entrée (55a) du premier convertisseur analogique-numérique (41) et

évaluer (140) le bon fonctionnement du circuit (38) de mesure de courant en comparant la valeur de mesure ($U_{1D}$) saisie à des résultats prédéterminés de mesure de consigne.

Fig. 1

Fig. 2

Fig. 3

Fig. 4

**EP 2 623 996 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5426416 A
- US 2011291675 A1
- DE 102005055272 B4